(19) **Europäisches Patentamt**
**European Patent Office**
**Office européen des brevets**

(11) **EP 4 130 880 A1**

(12) **EUROPEAN PATENT APPLICATION**

(43) Date of publication:
**08.02.2023 Bulletin 2023/06**

(21) Application number: **21189299.7**

(22) Date of filing: **03.08.2021**

(51) International Patent Classification (IPC):
**G03F 7/20** (1968.09)     **G06N 3/00** (2000.01)

(52) Cooperative Patent Classification (CPC):
**G03F 7/70525; G03F 7/705; G03F 7/70508; G06N 3/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **ADAL, Kedir, Mohammed**
**5500 AH Veldhoven, (NL)**

• **SAHRAEIAN, Reza**
**5500 AH Veldhoven (NL)**
• **VAN DIJK, Leon, Paul**
**5500 AH Veldhoven (NL)**
• **VAN HAREN, Richard, Johannes, Franciscus**
**5500 AH Veldhoven (NL)**
• **HAQUE, Abu, Niyam, Md, Mushfiqul**
**5500 AH, Veldhoven (NL)**

(74) Representative: **ASML Netherlands B.V.**
**Corporate Intellectual Property**
**P.O. Box 324**
**5500 AH Veldhoven (NL)**

(54) **METHODS OF DATA MAPPING FOR LOW DIMENSIONAL DATA ANALYSIS**

(57) Methods, systems, and apparatus for mapping high dimensional data related to an apparatus to a lower dimensional representation of the data. High dimensional data is obtained related to the apparatus. The high dimensional data has first dimensions N greater than 2. A nonlinear parametric model is obtained, which has been trained to map a training set of high dimensional data onto a lower dimensional representation. The lower dimensional representation has second dimensions M, wherein M is less than N. The model has been trained using a cost function configured to make the mapping preserve local similarities in the training set of high dimensional data. Using the model, the obtained high dimensional data is mapped to the corresponding lower dimensional representation.

**Fig. 7**

EP 4 130 880 A1

**Description**

<u>FIELD</u>

The present invention relates to methods, systems, and apparatus for mapping high dimensional data related to an apparatus to a lower dimensional representation and use of the resultant maps. In particular, it relates to mapping using nonlinear parametric models while preserving local similarities in the data.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Lithographic processes are complex, and result in the generation of large amounts of metrology data . Due to the complex nature and large number of variables involved in lithographic processes, many challenges exist in analyzing lithographic processes for understanding and improving those processes. Some of these challenges include how to get enough data, and how to process large amounts of data quickly and/or reduce computational load.

<u>SUMMARY</u>

According to an aspect of the disclosure, there is provided a method for mapping high dimensional data related to an apparatus to a lower dimensional representation of the data. The method comprises obtaining high dimensional data related to the apparatus, the high dimensional data having first dimensions N greater than 2. A nonlinear parametric model is obtained, which has been trained to map a training set of high dimensional data onto a lower dimensional representation. The lower dimensional representation has second dimensions M , wherein M is less than N. The model has been trained using a cost function configured to make the mapping preserve local similarities in the training set of high dimensional data. The obtained high dimensional data is mapped, using the model, to the corresponding lower dimensional representation.

Optionally, the nonlinear parametric model may be a neural network.

Optionally, the mapping may comprise, for each data point in the high dimensional data, a mapping to a corresponding data point in the lower dimensional representation.

Optionally, preserving local similarities may comprise minimizing pairwise similarity differences between data points in the high dimensional data, and corresponding data points in the lower dimensional representation.

Optionally, the cost function may be based on a symmetric pairwise similarity metric.

Optionally, the cost function C may be

$$C = KL(S||Q) = \sum_{i} \sum_{j} s_{ij} \log\left(\frac{s_{ij}}{q_{ij}}\right)$$

wherein KL is a Kullback-Leibler divergence, S is a similarity matrix consisting of pairwise similarities $S_{ij}$ in the high dimensional space, and Q is a similarity matrix of pairwise similarities qij in the lower dimensional representation space.

Optionally, the apparatus may be an apparatus in the semiconductor manufacturing industry.

Optionally, the apparatus may be one of a lithographic apparatus, a metrology apparatus, or an inspection apparatus.

Optionally, the obtained high dimensional data may comprise alignment data.

Optionally, the obtained high dimensional data may comprise overlay data.

Optionally, the obtained high dimensional data may comprise levelling data.

Optionally, the method may further comprise identifying a clustering in the corresponding lower dimensional representation, and determining one or more first dimensions associated with the clustering. The clustering may be associated with the local similarities in the high dimensional data.

Optionally, the method may further comprise determining, based on the lower dimensional representation, to perform maintenance of the apparatus.

Optionally, the method may further comprise outputting an alert to cause the maintenance to be performed.

Optionally, the method may further comprise determining, based on the lower dimensional representation, an adjustment to settings of the apparatus.

Optionally, the method may further comprise controlling the apparatus to cause the adjustment to be made.

Optionally, the method may further comprise determining, based on the lower dimensional representation, an adjustment of a lithographic exposure recipe.

Optionally, the method may further comprise implementing one or more changes to settings of the apparatus for causing the adjustment of the lithographic exposure recipe.

According to another aspect of the disclosure, there is provided a computer program configured to perform a method as described above.

According to another aspect of the disclosure, there is provided an apparatus comprising a processor and a memory comprising instructions which, when executed by the processor, cause the processor to perform a method as described above.

According to another aspect of the disclosure, there is provided a lithographic apparatus comprising an apparatus as described in the paragraph above.

According to another aspect of the disclosure, there is provided a litho cell comprising an apparatus according as described in the paragraphs above.

## BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic representation of a scatterometer;
- Figure 5 depicts a schematic representation of a level sensor;
- Figure 6 depicts a schematic representation of an alignment sensor;
- Figure 7 depicts a flow diagram of a method for mapping high dimensional data related to an apparatus to a lower dimensional representation of the data;
- Figure 8 (a)-(d) depicts example graphical lower dimensional representations of high dimensional data;
- Figure 9 depicts example graphical lower dimensional representations of high dimensional data; and
- Figure 10 depicts a schematic overview of a nonlinear parametric model for use in a lithographic fabrication application.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

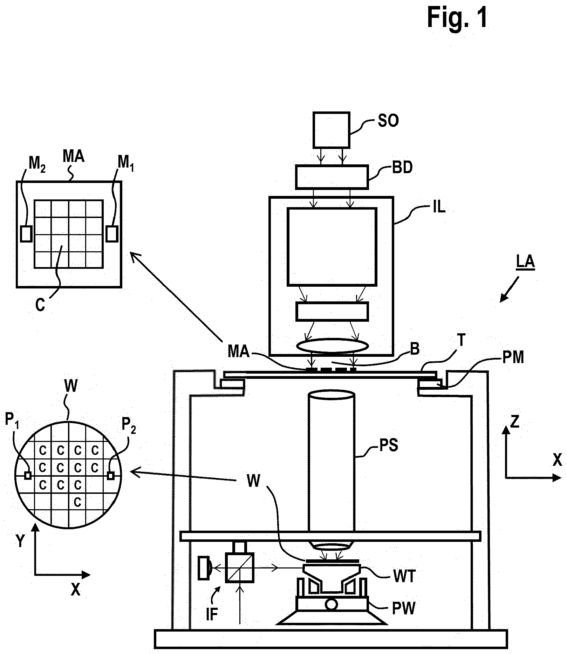

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

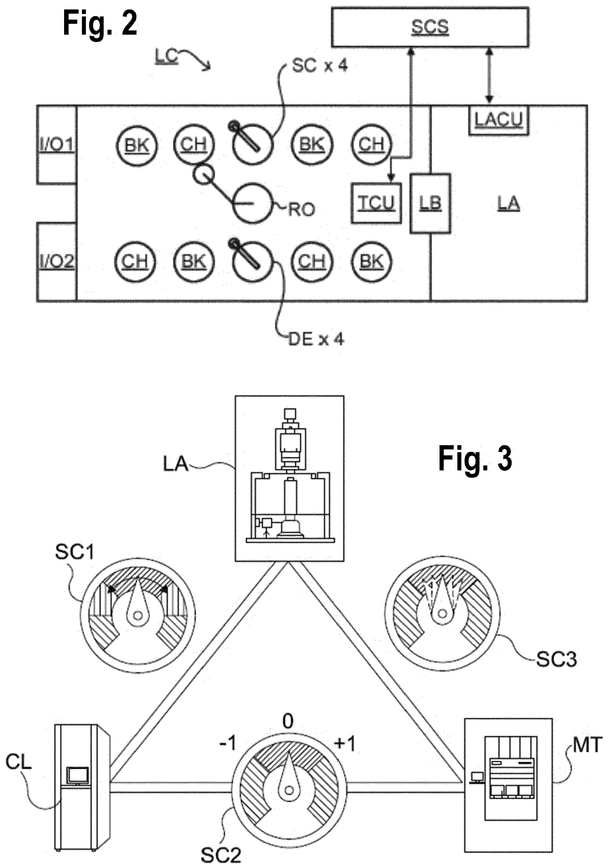

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation, which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

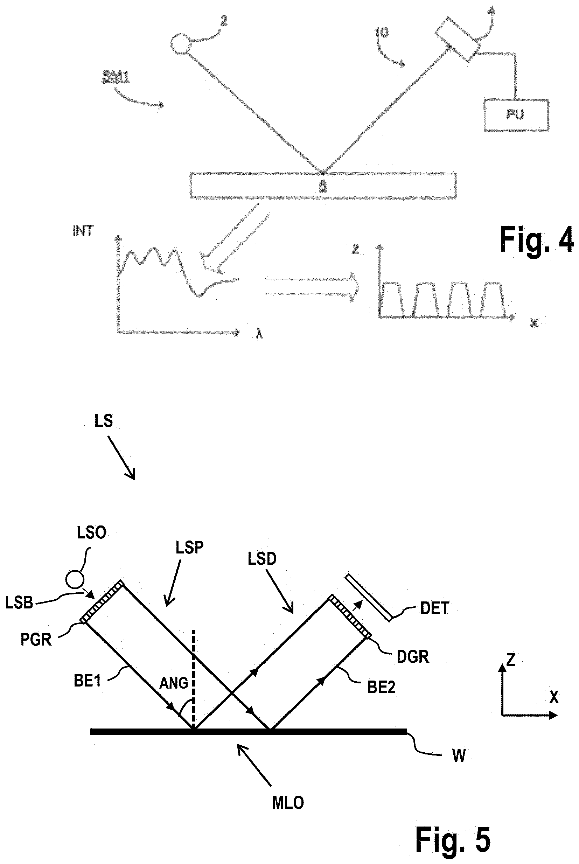

A metrology apparatus, such as a scatterometer SM1, is depicted in figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity INT as a function of wavelength λ) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A topography measurement system, level sensor or height sensor, and which may be integrated in the lithographic apparatus, is arranged to measure a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband radiation source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

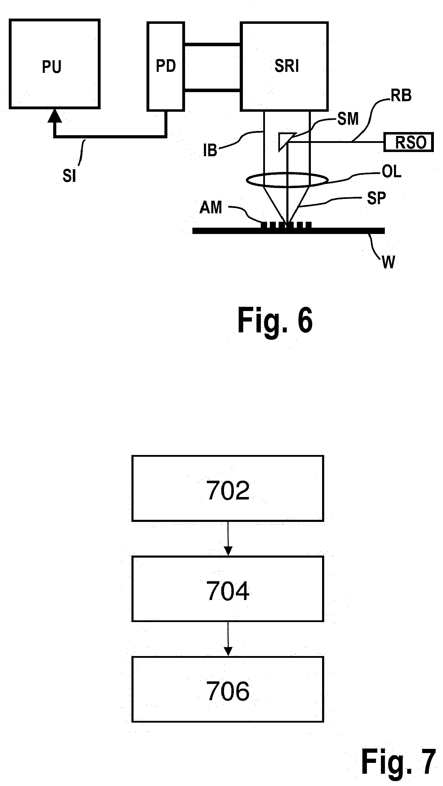

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

A lithographic apparatus may use metrology tools MT for measuring properties of the substrate, pattern, and apparatus before, during and/or after the lithographic patterning process. The metrology tools MT may use scanner metrology to measure for example substrate (also referred to as wafer) alignment, levelling maps, etc. Alignment AL and levelling LVL measurement data may for example be used for accurate positioning of a substrate on the wafer table, e.g. on a wafer table chuck. Scanner metrology data such as alignment AL and levelling LVL may be available for each substrate that is exposed by a lithographic apparatus. The scanner metrology data may be available for each exposed layer on a substrate. In contrast, some properties (e.g. overlay) may be measured only on a subset of substrates in a group of substrates (e.g. a lot of 25). As a result of being available for each exposed substrate, alignment and/or levelling data may be used to reduce an overlay error between patterned layers on a substrate. Because of its availability, scanner metrology data may be useful for comprehensive analysis of the substrate. The analysis may for example be aimed at finding hidden fingerprint sources for a substrate, and/or for inspection of a substrate demonstrating an excursion from an expected result. A fingerprint may be a unique characteristic, or unique set of characteristics, in the data values, that allows identification of any aspect of the lithographic apparatus and/or process. Models, such as machine learning models, including so called "deep" machine learning models (e.g. models containing more than one hidden layer), may provide a means to discover and identify hidden fingerprint sources. Advantageously, the models may achieve this discovery and identification in an unsupervised way from unlabeled metrology data. Identification of one or more hidden fingerprint sources may further enable the development of specific prediction models (e.g. virtual overlay metrology prediction for lithography) and/or classification models (e.g. excursion detection) for different applications related to the lithographic apparatus. These applications may for example include predictive maintenance, updating recipe settings, etc.

Scanner metrology data may be high dimensional. That is to say, it may deliver a large amount of data comprising a plurality of different parameters, each representing a different dimension. For example, metrology data may have of the order of 10 or more dimensions, for example 24 dimensions or more. Analyzing high dimensional data may require either a known model that can represent the high-dimensional data in a concise and interpretable way, or a means to map the high-dimensional data into lower-dimensional (2D or 3D) space. Lower dimensional representations of data may be more suitable for interpretation and analysis by humans compared to higher dimensional representations. Furthermore, using the lower dimensional representation data in automated analysis may be computationally cheaper and/or faster.

Dimensionality reduction techniques such as principal component analysis (PCA) are known, and may be commonly used to map high-dimensional into low-dimensional representation for fingerprint analysis. However, linear methods such as PCA are not always good at capturing nonlinear structures that exists in high-dimensional data. For many diagnostic applications, however, identifying hidden and complex fingerprint sources may be particularly beneficial. For instance, given metrology data gathered at a specific layer stack of a lithographically exposed substrate, it may be relatively straightforward to identify (e.g. using PCA or even observation) fingerprints caused by the scanners and chucks used at that layer. However, the fingerprint contributions coming from several scanner-chuck combinations as several layer stacks of the wafers are processed may be complex and difficult to capture with PCA.

As an alternative to PCA, nonlinear embedding techniques may be able to model and reveal complex structures in high dimensional data. As a result, nonlinear embedding techniques may allow identification of subtle fingerprints in high-dimensional data. However, learning a parametric model that can accurately capture complex nonlinear relationships in high-dimensional data is a challenging problem. Furthermore, existing state-of-the-art nonlinear embedding techniques, such as t-Distributed Stochastic Neighbor Embedding (tSNE), do not provide an explicit function that maps newly acquired wafer data to an already learned map. An explicit mapping function is particularly beneficial for applying trained models in a fabrication environment where there is a desire for real-time analysis. For example, in a lithographic fabrication environment substrates may processed continuously, and inference for each wafer may be needed to be made in real time. Another challenge may be that creating nonlinear embedding functions, for example using deep machine learning models, may involve computationally expensive operations. Using prior techniques, it could take several days to train such models, which may render them impractical for some uses, such as continuously running applications related to a lithographic apparatus (such as predictive maintenance, recipe updates, etc.). In addition, approximations to simplify computational complexity often lead to suboptimal results.

To overcome at least some of the challenges mentioned above, it is proposed herein to use a nonlinear parametric model to map high dimensional data onto a lower dimensional space. An example of a nonlinear parametric model may be a deep neural network (DNN) model, as DNN models are capable in successfully modeling a wide variety of complex functions using hierarchical features that can be extracted in unsupervised ways. Once trained, DNN models may also be suitable and easy to deploy into production environments.

Figure 7 depicts a flow diagram of a method for mapping high dimensional data related to an apparatus to a lower dimensional representation of the data. High dimensional data is obtained 702 related to the apparatus. The high dimensional data has first dimensions N, wherein N is greater than 2. A nonlinear parametric model is obtained 704, which has been trained to map a training set of high dimensional data onto a lower dimensional representation. The lower dimensional representation has second dimensions M, wherein M is less than N. The model has been trained using a cost function configured to make the mapping preserve local similarities in the training set of high dimensional data. The training algorithm may be a backpropagation algorithm. In step 706, the obtained high dimensional data is mapped, using the model, to the corresponding lower dimensional representation.

Each data point in the high dimensional data may have a corresponding data point in the lower dimensional representation. The mapping by the trained model may comprise, for each data point in the high dimensional representation, a mapping to its corresponding data point in the lower dimensional representation. A data point may also be referred to as a sample.

Pairwise similarities between pairs of data points may be determined. These pairwise similarities may be calculated for both the high dimensional data points and the lower dimensional representation data points. Once both sets of pairwise similarities have been calculated, preserving local similarities may comprise minimizing the differences between the pairwise similarities of the high dimensional data and the low dimensional data. This may be done using the cost function and training the model using, for example backpropagation.

In order to capture similar high-dimensional values in data points of the data set, nonlinear embedding techniques may involve computing pairwise similarities between the newly captured data points using distance metrics, for example Euclidean distance (although other distance measurements may be used). The distance metrics may be calculated between all sample pairs of data points. The distance metrics may be calculated both in the newly captured high dimensional data, and in the low dimensional representation of that data. Once the distance metrics have been calculated, an objective, or a cost function using the distance metrics may be optimised. The objective/cost function may minimize differences between the computed pairwise similarities of the high-dimensional measurements and the low-dimensional representations.

Generally, the cost function may be optimized with or without a function that can capture the transformation from high-dimensional to low-dimensional space. If it is optimized without a function, as done in techniques such as tSNE, then newly acquired measurements cannot be incorporated into an existing map. On the other hand, if the optimization is done together with a function that models the transformation, such as a non-linear parametric model (for example a DNN), then once trained, the function may be used to incorporate new data into an existing map. Note that in both cases the same objective function may be optimized. An advantage of the method described above, therefore, is that the model provides an explicit way to include newly acquired high-dimensional data in the learned map.

An example nonlinear parametric model is a deep neural network DNN. Although DNNs may enable modeling any nonlinear embedding function, they may also pose additional complexity when training with a larger number of data points. During DNN model training iterations, training samples may be regularly shuffled in order to reduce the risk of the optimization algorithm getting stuck in a bad local minimum of the cost function. This reshuffling of the samples may require either re-computing the pairwise similarities for all shuffled sample pairs, or creating a look up table to fetch previously computed values. Both approaches are computationally expensive, especially when the training samples are large, that is to say, if the data points have a high dimensionality. In some example implementations, the models described herein are able to be effectively trained in a couple of hours, whilst also being able to capture high dimensional similarities and maintain them in the lower dimensional representation. This advantage may be achieved by replacing computationally expensive operations (such as re-computing pairwise similarities) by simple linear operations that are faster at least by an order of magnitude. Once trained, the model further provides an advantage that it may create a mapping function from the high dimensional data to the lower dimensional representation, which is advantageous for real-time fabrication-linked applications. Another advantage of having a model that may be trained in a couple of hours may be that the model may be retrained when more data becomes available. Due to the fast training times, the effects of the new data may be put into action quickly (the training duration, i.e. a couple of hours) after the data was provided/produced. This may be allow the models to take into account drift in the data (e.g. features of the apparatus slowly changing over time) whilst the apparatus is running.

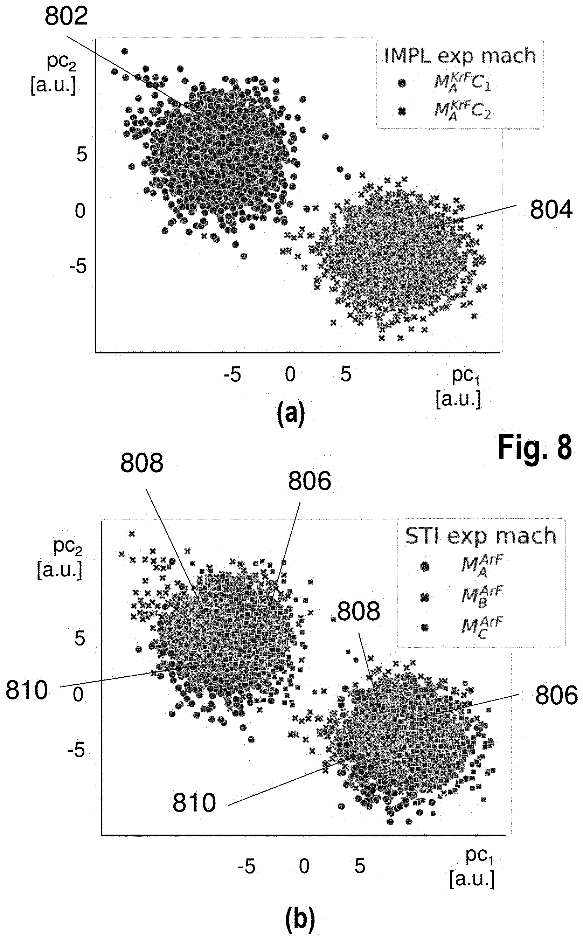

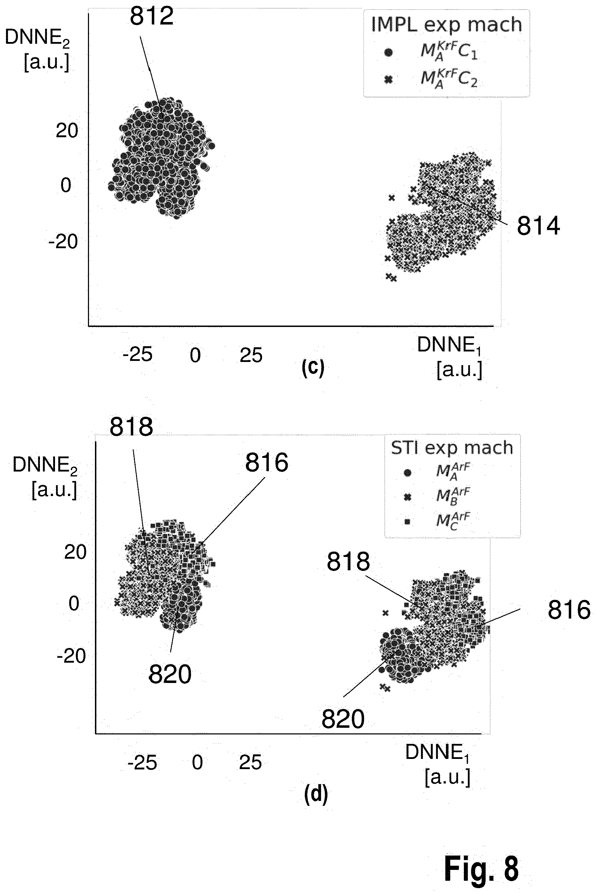

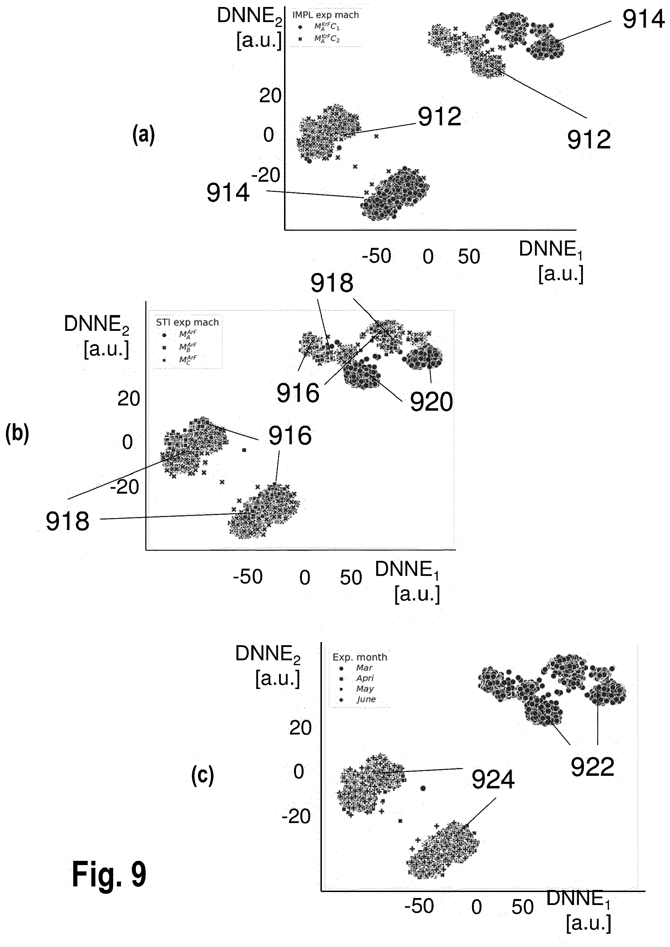

Due to the faster training process, a more complex (e.g. a deep neural net having more layers) model may be trained in a faster amount of time. Due to the non-linear parametric nature and/or the increased depth/complexity of the model, the model may be better able to preserve local similarities. As a result, the lower dimensional representation may be able to identify smaller differences in the data. Examples of this increased identification of differences by DNNs is described in relation to figures 8 and 9 below.

The proposed DNN-based parametric nonlinear embedding techniques described above aims at preserving local similarities between pairs of samples. Therefore, it may involve computation of an affinity or similarity matrix between all training sample pairs. For $N$ training samples, a similarity matrix of $N \times N$ may be computed. The cost function optimized may be given by:

$$C = KL(S \parallel Q) = \sum_{i} \sum_{j} s_{ij} log \frac{s_{ij}}{q_{ij}},$$

In the above formula, $S$ and $Q$ may represent the pairwise similarities between all sample pairs in the high-dimensional and low-dimensional representation, respectively. $s_{ij}$ may represent a pairwise similarity between sample I and sample j in the high dimensional space. $q_{ij}$ may represent a pairwise similarity between sample I and sample j in the lower representation space. KL may represent a Kullback-Leibler divergence. This cost function is not convex, and in order to reduce the risk of the optimization algorithm from getting stuck into bad local minimum, random shuffling of training samples may be regularly applied during DNN training. This in turn may require either recomputing the similarity matrix S again, or looking up each of the pairwise similarities after shuffling. This may be a time-consuming and/or computationally expensive process. A derivation of a technique to train the proposed DNN based nonlinear embedding accurately and efficiently is set out below. This technique may be used in relation to the training of the nonlinear parametric models described herein.

Let $X$ be a matrix representation of a set of $N$ m-dimensional training data points, $x_i \in \mathbb{R}^m$

$$X = \begin{bmatrix} x_1^1 & x_1^2 & \cdots & x_1^m \\ x_2^1 & x_2^2 & \cdots & \vdots \\ \vdots & \vdots & \ddots & \vdots \\ x_N^1 & \cdots & \cdots & x_N^m \end{bmatrix}$$

and $S$ be a similarity matrix consisting of pairwise similarities $s_{ij}$ in the high-dimensional space between two samples $i$ and $j$ can be written as

$$S = \begin{bmatrix} s_{11} & s_{12} & \cdots & s_{1N} \\ s_{21} & s_{22} & \cdots & \vdots \\ \vdots & \vdots & \ddots & \vdots \\ s_{N1} & \cdots & \cdots & s_{NN} \end{bmatrix}$$

where

$$s_{ij} = \frac{e^{-d_{ij}/2\sigma^2}}{\sum_{k \neq l} e^{-d_{kl}/2\sigma^2}} \qquad (1)$$

and $d_{ij}$ is the square of pairwise Euclidean distance between samples $i$ and $j$

$$d_{ij} = \left\| x_i - x_j \right\|^2 \qquad (2)$$

The entries of the symmetric pairwise similarity matrix S may thus be determined by the pairwise Euclidean distances $d_{ij}$. For all the samples, the pairwise Euclidean distances is a symmetric matrix with $N \times N$ is given by

$$D = \begin{bmatrix} 0 & d_{12} & \cdots & d_{1N} \\ d_{21} & 0 & \cdots & \vdots \\ \vdots & \vdots & \ddots & \vdots \\ d_{N1} & \cdots & \cdots & 0 \end{bmatrix}$$

The pairwise Euclidean distances D can be computed from the high-dimensional samples as follows

$$
D = \begin{bmatrix} \langle x_1, x_1 \rangle \\ \langle x_2, x_2 \rangle \\ \vdots \\ \langle x_N, x_N \rangle \end{bmatrix} \vec{1} + \vec{1}^T [\langle x_1, x_1 \rangle \quad \langle x_2, x_2 \rangle \quad \cdots \quad \langle x_N, x_N \rangle] - 2XX^T \tag{3}
$$

where $\vec{1} = [1\ 1 \cdots 1]$ is a vector of N entries of 1.

When the samples are shuffled, the pairwise Euclidean distances remain the same; however, their relative position in D changes. Mathematically, shuffling the samples is equivalent to multiplying the matrix of high-dimensional data points X on the left by a permutation matrix P as follows

$$
X^{new} = PX \tag{4}
$$

Where a permutation matrix P is a square matrix that has exactly one entry of 1 in each row and column. An example permutation matrix that swaps the first two samples would be an identity matrix with the first two rows swapped as follows

$$
P = \begin{bmatrix} 0 & 1 & \cdots & 0 \\ 1 & 0 & \cdots & \vdots \\ \vdots & \vdots & 1 & \vdots \\ 0 & \cdots & \cdots & 1 \end{bmatrix}
$$

After the samples are shuffled by *P*, the new (shuffled) pairwise Euclidean distances *D$^{new}$* is given by

$$
D^{new} = P \begin{bmatrix} \langle x_1, x_1 \rangle \\ \langle x_2, x_2 \rangle \\ \vdots \\ \langle x_N, x_N \rangle \end{bmatrix} \vec{1} + \vec{1}^T [\langle x_1, x_1 \rangle \quad \langle x_2, x_2 \rangle \quad \cdots \quad \langle x_N, x_N \rangle] P^T - 2(PX)(PX)^T \tag{5}
$$

Using the property of permutation matrices that *PP$^T$ = I,* equation 5 can also be written as

$$
D^{new} = P \begin{bmatrix} \langle x_1, x_1 \rangle \\ \langle x_2, x_2 \rangle \\ \vdots \\ \langle x_N, x_N \rangle \end{bmatrix} \vec{1} PP^T + PP^T \vec{1}^T [\langle x_1, x_1 \rangle \quad \langle x_2, x_2 \rangle \quad \cdots \quad \langle x_N, x_N \rangle] P^T - P(2XX^T)P^T \tag{6}
$$

It is also noted that

$$
\vec{1}P = \vec{1} \tag{7}
$$

Substituting equation 7 into equation 6 and applying matrix factorization, the new pairwise squared Euclidean distances matrix may be simplified to

$$
D^{new} = P \left( \begin{bmatrix} \langle x_1, x_1 \rangle \\ \langle x_2, x_2 \rangle \\ \vdots \\ \langle x_N, x_N \rangle \end{bmatrix} \vec{1} + \vec{1}^T [\langle x_1, x_1 \rangle \quad \langle x_2, x_2 \rangle \quad \cdots \quad \langle x_N, x_N \rangle] - 2XX^T \right) P^T
$$

$$
D^{new} = PDP^T \tag{8}
$$

Therefore, it is possible for *D* (and similarity matrix S) to be computed accurately only once for all pairs of

**EP 4 130 880 A1**

samples. The result may be reused during DNN training by a simple matrix multiplication operation with a randomly generated shuffling matrix *P*. Unlike splitting the training samples into batches and computing similarities for each batch, the technique described above may accurately capture the overall similarities between all pairs of samples. This may speed up the DNN based nonlinear model training in which samples are shuffled in every iteration.

An accurate and computationally efficient method to address these challenges may be applied in some of the methods described herein, and as example is described in more detail below. In summary, sample reshuffling may be improved by modelling the sample shuffling step using computationally less expensive linear operators. These linear operators may be manageable in each iteration. This may enable computationally expensive operations to be done only once at the beginning, and may allow reusing the results in the subsequent iterations. Experiments involving data from 17,100 substrates has shown that this method may enable a reduction in computational time by a factor of 19 (i.e. 4 vs. 75 seconds) in each iteration.

The method described above may be applied to capture hidden fingerprint sources on measurement data gathered from a lithographic apparatus. The data may comprise for example alignment residuals data of a large number of production substrates (e.g. around 17,000). The measurement data may have been processed on different scanners. For example, the alignment data may have been processed on three ArF (argon fluoride) and two KrF (krypton fluoride) scanners for patterning Shallow-Trench-Isolation (STI) and implant (IMPL) layers, respectively. The measurement data may have been obtained from a plurality of targets on each substrate. Each target read may represent a different dimension N of data for a specific substrate. In the example discussed herein, the alignment measurements may be readouts from 24 target locations when the IMPL layers are exposed, thereby resulting in a 24-dimensional map. Further data, for example levelling data and/or alignment data, may also have been obtained for the substrates. These may be used for analysis, and/or control of the analysis process.

Figure 8 depicts a lower dimensional representation of high dimensional data processed according to different methods. Specifically, the high dimensional data may be for example 24-dimensional alignment measurements of lithographic substrates as described above.

In figures 8(a) and 8(b), a PCA based linear embedding technique was used to determine the lower dimensional representation. As shown, the 24 dimensions of the high dimensional data have been reduced to a 2-dimensional space, and represented graphically. The axes may represent the lower dimensions, which do not necessarily need to have a physically meaningful interpretation. In figure 8(a), two separate clusters 802 and 804 may be clearly distinguished. This clustering may represent a first fingerprint contribution corresponding to the largest variation in the high dimensional data, which has been preserved in the 2D representation. This largest variation may for example be caused by using 2 difference chucks in one of the KrF scanners. As expected, the largest variation was able to be captured by the PCA based linear embedding technique. However, a second fingerprint contribution of a second variation scanners was not captured well. In figure 8(b), data points 806, 808, and 810 corresponding to the 3 different ArF scanners are not identified as separated clusters. This illustrates the limitations of the PCA based linear embedding technique in identifying complex fingerprints.

In figures 8(c) and 8(d), a nonlinear parametric model was used to map the high dimensional data onto a lower dimensional (in this instance, 2D) representation. The model may be a DNN based nonlinear embedding technique. As may be seen, both the first fingerprint contribution (clusters 812 and 814) and the second fingerprint contribution (clusters 816, 818, 820) may be identified from the lower dimensional representation. In the context of this specific example, first set of clusters 812 and 814 relates to the different chucks in the KrF scanner, and the second set of clusters relates to the different ArF scanners. This illustrates that the nonlinear parametric model may be more sensitive, and better able to preserve complex fingerprint contributions in the high dimensional data.

In Figure 9, an example is shown in which apart from the fingerprint sources described in relation to figure 8 above, a further fingerprint contribution may be identified. The graphs represent a lower dimensional representation mapped by a nonlinear parametric model as described herein. In figure 9(a), clusters 912 and 914 are labelled, which may identify the first fingerprint contribution. The first fingerprint contribution may correspond to a variation caused by two different chuck used in a KrF scanner. In figure 9(b), clusters 916, 918, and 920 are labelled, which may identify a second fingerprint contribution. The second fingerprint contribution may correspond to a variation caused by different ArF scanners used on the substrates. Using the proposed nonlinear parametric model may furthermore be able to reveal a third fingerprint variation over time (see Figure 9(c)). This third fingerprint contribution may be represented by clusters 922 and 924. Cluster 922 may contain data points obtained in March, while cluster 924 may contain data points obtained in April, May, and June. This may indicate something in the process changed in the time between the data obtained in March, and the data obtained in the later months. This scanner fingerprint change over time may be due to several factors. It may for example appear after scanner maintenance, or may appear because of process drift over time. This identification by the model, may be used to trigger subsequent measures, such as drift detection mechanism, to take into account the fingerprint change over time.

Although the improvement demonstrated and described above are based on alignment measurements, the invention may also be applied to other high-dimensional scanner data, for example levelling data maps, and/or measurements from other metrology tools. Furthermore, it may also be possible to incorporate local similarity metrics in terms of probability or other distance metrics than Euclidean distance.

Based on the examples described in relation to figures 8 and 9 above, the methods described herein may further comprise identifying a clustering of two or more clusters in the lower dimensional representation. For each of the identified clusters, one or more dimensions of the high dimensional data may be identified that are associated with the clustering. The clustering may be associated with local similarities in associated identified dimensions of the high dimensional data.

Analysis of the lower dimensional representation/fingerprints may be performed by one or more persons. Alternatively or additionally, analysis may be performed by one or more further models. Based on analysis of the identified fingerprint, one or more actions may be taken in relation to the lithographic process to which the high dimensional data relates. The action may for example comprise a decision to perform maintenance of the lithographic apparatus. The identified clusters may be used to determine when to perform maintenance. The identified dimensions may be used to determine which parts of the apparatus to perform maintenance on. In another example, the action may comprise making an adjustment to the settings of the apparatus. Based on the lower dimensional representation, and/or related identified fingerprints, the method may comprise determining an adjustment to the settings of the lithographic apparatus, and/or recipe settings for the exposure of the substrate. The method may comprise outputting, in response to analysis, an alert to perform an action, for example an alert to perform maintenance on the apparatus, or to make an adjustment to the settings of the apparatus. The method may further comprise controlling an apparatus to perform an action, for example implementing the determined adjustment to the apparatus.

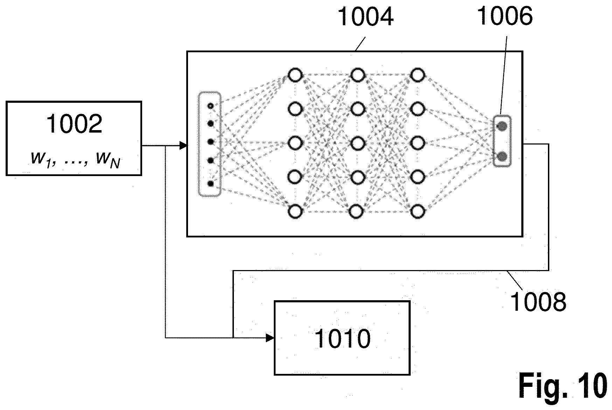

Figure 10 depicts a schematic overview of proposed feed-forward use of a nonlinear parametric model 1004 for use in a lithographic fabrication application. Specifically, a nonlinear DNN embedding model 1004 with a cost function as described above may obtain high dimensional data wi, ..., $W_N$ 1002 related to one or more lithographic apparatus and/or lithographically patterned substrates, wi, ..., $W_N$ may be high dimensional substrate scanner metrology data 1002, having N dimensions, wherein N is significantly greater than 2. The high dimensional data may be provided as input to the model 1004. The model 1004 may process the high dimensional data 1004 to determine a lower dimensional representation 1006. The lower dimensional representation may have M dimensions. M may for example be 2 or 3. M = 2 or M = 3 are advantageous choices are they are suitable for graphic representations that are suitable for interpretation by human analysts. Based on the lower dimensional representation 1006, fingerprints 1008 within the high dimensional data 1002 may be identified. The fingerprints 1008 may be identified through analysis of the lower dimensional representation, wherein the analysis may include for example analysis by a human analyst, or processing by one or more models. The fingerprints 1008 may be provided, possibly alongside the high dimensional data 1002, to prediction and/or classification models 1010, and/or any other applications related to the data.

Although described herein in relation to a lithographic apparatus, it should be understood that the methods described herein may be used in relation to high dimensional data related to other apparatuses and systems. Example applications having high dimensional data may include meteorology systems (e.g. for weather prediction), complex manufacturing apparatuses, image analysis (e.g. handwriting recognition, medical image analysis, etc).

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Further embodiments of the invention are disclosed in the list of numbered clauses below:

1. A method for mapping high dimensional data related to an apparatus to a lower dimensional representation of the data, the method comprising: obtaining high dimensional data related to the apparatus, the high dimensional data having first dimensions N greater than 2; obtaining a nonlinear parametric model which has been trained to map a training set of high dimensional data onto a lower dimensional representation, the lower dimensional representation having second dimensions M, wherein M is less than N, and wherein the model has been trained using a cost function configured to make the mapping preserve local similarities in the training set of high dimensional data; and mapping, using the model, the obtained high dimensional data to the corresponding lower dimensional representation.

2. A method according to clause 2, wherein the nonlinear parametric model is a neural network.

3. A method according to any of the preceding clauses, wherein the mapping comprises, for each data point in the high dimensional data, a mapping to a corresponding data point in the lower dimensional representation.

4. A method according to any of the preceding clauses, wherein preserving local similarities comprises minimizing pairwise similarity differences between data points in the high dimensional data, and corresponding data points in the lower dimensional representation.

5. A method according to any of the preceding clauses, wherein the cost function is based on a symmetric pairwise similarity metric.

6. A method according to clause 5 when dependent on clause 3, wherein the cost function C is

$$C = KL(S||Q) = \sum_i \sum_j s_{ij} \log\left(\frac{s_{ij}}{q_{ij}}\right)$$

wherein KL is a Kullback-Leibler divergence, S is a similarity matrix consisting of pairwise similarities $S_{ij}$ in the high dimensional space, and Q is a similarity matrix of pairwise similarities qij in the lower dimensional representation space.

7. A method according to any of the preceding clauses, wherein the apparatus is an apparatus in the semiconductor manufacturing industry.

8. A method according to clause 3, wherein the apparatus is one of a lithographic apparatus, a metrology apparatus, or an inspection apparatus.

9. A method according to clause 8, wherein the obtained high dimensional data comprises alignment data.

10. A method according to any of clauses 8 - 9, wherein the obtained high dimensional data comprises overlay data.

11. A method according to any of clauses 8 - 10, wherein the obtained high dimensional data comprises levelling data.

12. A method according to any of the preceding clauses, further comprising identifying a clustering in the corresponding lower dimensional representation; and determining one or more first dimensions associated with the clustering, wherein the clustering is associated with the local similarities in the high dimensional data.

13. A method according to any of the preceding clauses, further comprising: determining, based on the lower dimensional representation, to perform maintenance of the apparatus.

14. A method according to clause 13, further comprising: outputting an alert to cause the maintenance to be performed.

15. A method according to any of the preceding clauses, further comprising: determining, based on the lower dimensional representation, an adjustment to settings of the apparatus.

16. A method according to clause 15, further comprising: controlling the apparatus to cause the adjustment to be made.

17. A method according to clause 8, further comprising: determining, based on the lower dimensional representation, an adjustment of a lithographic exposure recipe.

18. A method according to clause 17, further comprising: implementing one or more changes to settings of the apparatus for causing the adjustment of the lithographic exposure recipe.

19. A computer program configured to perform a method according to any of clauses 1 - 18.

20. An apparatus comprising a processor and a memory comprising instructions which, when executed by the processor, cause the processor to perform a method according to any of clauses 1 - 18.

21. A lithographic apparatus comprising an apparatus according to clause 20.

22. A litho cell comprising an apparatus according to any of clauses 20 - 21.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

**Claims**

1.  A method for mapping high dimensional data related to an apparatus to a lower dimensional representation of the data, the method comprising:

    obtaining high dimensional data related to the apparatus, the high dimensional data having first dimensions N greater than 2;
    obtaining a nonlinear parametric model which has been trained to map a training set of high dimensional data onto a lower dimensional representation, the lower dimensional representation having second dimensions M, wherein M is less than N, and wherein the model has been trained using a cost function configured to make the mapping preserve local similarities in the training set of high dimensional data; and
    mapping, using the model, the obtained high dimensional data to the corresponding lower dimensional representation.

2.  A method according to claim 2, wherein the nonlinear parametric model is a neural network.

3.  A method according to any of the preceding claims, wherein the mapping comprises, for each data point in the high dimensional data, a mapping to a corresponding data point in the lower dimensional representation.

4.  A method according to any of the preceding claims, wherein preserving local similarities comprises minimizing pairwise similarity differences between data points in the high dimensional data, and corresponding data points in the lower dimensional representation.

5.  A method according to any of the preceding claims, wherein the cost function is based on a symmetric pairwise similarity metric.

6.  A method according to claim 5 when dependent on claim 3, wherein the cost function C is

$$C = KL(S||Q) = \sum_i \sum_j s_{ij} \log\left(\frac{s_{ij}}{q_{ij}}\right)$$

    wherein KL is a Kullback-Leibler divergence, S is a similarity matrix consisting of pairwise similarities $S_{ij}$ in the high dimensional space, and Q is a similarity matrix of pairwise similarities qij in the lower dimensional representation space.

7.  A method according to any of the preceding claims, wherein the apparatus is an apparatus used in a semiconductor manufacturing process.

8.  A method according to claim 7, wherein the apparatus is one of a lithographic apparatus, a metrology apparatus, or an inspection apparatus.

9.  A method according to claim 8, wherein the obtained high dimensional data comprises one or more of: alignment data, overlay data or levelling data.

10. A method according to any of the preceding claims, further comprising: identifying a clustering in the corresponding lower dimensional representation; and determining one or more first dimensions associated with the clustering, wherein the clustering is associated with the local similarities in the high dimensional data.

11. A method according to any of the preceding claims, further comprising:
    determining, based on the lower dimensional representation, whether to perform a maintenance action to the apparatus.

12. A method according to claim 11, further comprising outputting an alert to cause the maintenance to be performed.

13. A method according to any of the preceding claims, further comprising: determining, based on the lower dimensional representation, an adjustment to settings of the apparatus.

**14.** A method according to claim 13, further comprising: controlling the apparatus to cause the adjustment to be made.

**15.** A computer program configured to perform a method according to any of claims 1 to 14.

# Fig. 1

# Fig. 2

LC

SC x 4

SCS

LACU

I/O1

BK  CH  BK  CH

RO

TCU  LB  LA

I/O2

CH  BK  CH  BK

DE x 4

LA

# Fig. 3

SC1

SC3

CL

0

-1      +1

SC2

MT

Fig. 4

Fig. 5

PU    PD    SRI

RB

SM

IB    RSO

OL

AM    SP

W

SI

**Fig. 6**

702

704

706

**Fig. 7**

Fig. 8

(a)

(b)

Fig. 8

Fig. 9

Fig. 10

**EP 4 130 880 A1**

# EUROPEAN SEARCH REPORT

**Application Number**

EP 21 18 9299

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2019/304079 A1 (MIN RENQIANG [US] ET AL) 3 October 2019 (2019-10-03)<br>* abstract *<br>* figures 1-3,6 *<br>* paragraphs [0002] – [0004], [0017] – [0020], [0023], [0026], [0029] – [0032], [0040] – [0049] *<br>----- | 1-6,<br>10-15<br>7-9 | INV.<br>G03F7/20<br>G06N3/00 |
| X<br><br><br><br>A | MATSUNAWA TETSUAKI ET AL: "Laplacian eigenmaps and bayesian clustering based layout pattern sampling and its applications to hotspot detection and OPC",<br>2016 21ST ASIA AND SOUTH PACIFIC DESIGN AUTOMATION CONFERENCE (ASP-DAC), IEEE, 25 January 2016 (2016-01-25), pages 679-684, XP032877665,<br>DOI: 10.1109/ASPDAC.2016.7428090<br>[retrieved on 2016-03-07]<br>* the whole document *<br><br>----- | 1-3,5-7,<br>10,15<br><br><br><br>4,8,9,<br>11-14 | TECHNICAL FIELDS SEARCHED (IPC)<br><br>G03F<br>G06N |

The present search report has been drawn up for all claims

| Place of search | Date of completion of the search | Examiner |
|---|---|---|
| Munich | 20 January 2022 | Andersen, Ole |

EPO FORM 1503 03.82 (P04C01)

## ANNEX TO THE EUROPEAN SEARCH REPORT
## ON EUROPEAN PATENT APPLICATION NO.

EP 21 18 9299

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2022

| Patent document cited in search report | Publication date | Patent family member(s) | Publication date |
|---|---|---|---|
| US 2019304079 A1 | 03-10-2019 | NONE | |

For more details about this annex : see Official Journal of the European Patent Office, No. 12/82

## REFERENCES CITED IN THE DESCRIPTION

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 7265364 B
- US 7646471 B
- US 2010233600 A1
- WO 2016102127 A1
- US 6961116 B
- US 2015261097 A1
- US 2009195768 A